(19)

**Europäisches Patentamt**
**European Patent Office**
**Office européen des brevets**

(11) **EP 3 170 213 B1**

(12) **EUROPEAN PATENT SPECIFICATION**

(45) Date of publication and mention
of the grant of the patent:
**17.06.2020 Bulletin 2020/25**

(51) Int Cl.:
*H01L 51/44* *(2006.01)*      *H01L 51/52* *(2006.01)*
*H01L 31/055* *(2014.01)*

(21) Application number: **15741266.9**

(22) Date of filing: **15.07.2015**

(86) International application number:
**PCT/GB2015/052046**

(87) International publication number:
**WO 2016/009203 (21.01.2016 Gazette 2016/03)**

(54) **COMPOSITE LIGHT HARVESTING MATERIAL AND DEVICE**

LICHTSAMMELNDES VERBUNDMATERIAL UND VORRICHTUNG

DISPOSITIF ET MATÉRIAU COMPOSITE DE COLLECTE DE LUMIÈRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.07.2014 GB 201412517**

(43) Date of publication of application:
**24.05.2017 Bulletin 2017/21**

(73) Proprietors:
• **Cambridge Enterprise Limited**
**Cambridge, Cambridgeshire CB2 1TN (GB)**
• **King Abdulaziz City for**
**Science & Technology (KACST)**
**11442 Riyadh (SA)**

(72) Inventors:
• **RAO, Akshay**
**Cambridge CB3 0GT (GB)**
• **EHRLER, Bruno**
**Cambridge CB3 0GT (GB)**
• **FRIEND, Richard Henry**
**Cambridge CB3 0GT (GB)**
• **TABACHNYK, Maxim**
**Cambridge CB3 0GT (GB)**

(74) Representative: **TLIP Limited**
**14 King Street**
**Leeds LS1 2HL (GB)**

(56) References cited:
**EP-A2- 2 368 962**          **WO-A1-2013/054818**
**WO-A1-2014/052530**        **US-A1- 2013 240 850**

• **EHRLER BRUNO ET AL: "Hybrid pentacene/a-silicon solar cells utilizing multiple carrier generation via singlet exciton fission", APPLIED PHYSICS LETTERS, AMERICAN INSTITUTE OF PHYSICS, 2 HUNTINGTON QUADRANGLE, MELVILLE, NY 11747, vol. 101, no. 15, 8 October 2012 (2012-10-08), pages 153507-153507, XP012165301, ISSN: 0003-6951, DOI: 10.1063/1.4757612 [retrieved on 2012-10-10]**
• **KOEPPE ET AL: "Advanced photon-harvesting concepts for low-energy gap organic solar cells", SOLAR ENERGY MATERIALS AND SOLAR CELLS, ELSEVIER SCIENCE PUBLISHERS, AMSTERDAM, NL, vol. 91, no. 11, 26 April 2007 (2007-04-26), pages 986-995, XP022047682, ISSN: 0927-0248, DOI: 10.1016/J.SOLMAT.2007.01.008**
• **DO YOUNG KIM ET AL: "PbSe Nanocrystal-Based Infrared-to-Visible Up-Conversion Device", NANO LETTERS, vol. 11, no. 5, 11 May 2011 (2011-05-11), pages 2109-2113, XP55137258, ISSN: 1530-6984, DOI: 10.1021/nl200704h**

## Description

The present invention relates, in general, to the composition of organic semiconductors capable of multiple exciton generation. Particular compositions can be used in photovoltaic and light emitting devices to give enhanced efficiencies.

Conventional solar cells are limited in efficiency to around 34%, mainly due to the thermalisation of above-bandgap photons and transmission of below-bandgap photons. The limit in efficiency is called the Shockley-Queisser limit.

A number of strategies have been used to make solar cells that exceed the Shockley-Queisser limit. Such strategies can involve the use of organic and inorganic tandem cells. However, it has been challenging to match the current of the sub-cells in these designs. Efficient transfer of energy between organic and inorganic semiconductors is a widely sought after property, with applications in photovoltaics (PVs), light emitting-diodes and sensors. To date, efforts to couple organic and inorganic semiconductors have focussed on the transfer of singlet excitons via Förster resonance and energy transfer (FRET).

US 2010/0193011 A (MAPEL ET AL) 05/08/2010 discloses solar concentrators to improve the efficiency of PV cells. The solar concentrator comprises an emitting chromophore effective to receive at least some energy by Förster energy transfer from another chromophore. The emitting chromophore emits some of the received energy at a wavelength that is red-shifted from the wavelength absorbed by the other chromophore.

Another strategy to make a solar cell that exceeds the Shockley-Queisser limit is disclosed in EHRLER, Bruno, et al. Singlet Exciton Fission-Sensitized Infrared Quantum Dot Solar Cells. Nano Lett.. 2012, vol.12, p. 1053-1057. Ehrler et al demonstrate an organic/inorganic hybrid photovoltaic device architecture that uses singlet exciton fission to permit the collection of two electrons per absorbed high-energy photon while simultaneously harvesting low-energy photons. Singlet exciton fission is a well-established process in organic semiconductors by which a photogenerated singlet exciton couples to a nearby molecule in the ground state, creating two triplet excitons. The transfer of triplet excitons is desirable because triplet excitons possess properties such as long lifetimes, up to several ms, and diffusion lengths up to several $\mu$m. However, the transfer of triplet excitons via Förster resonant energy transfer is spin forbidden as discussed in SCHOLES, G.D, et al. Long range resonance energy transfer in molecular systems. Annual review of physical chemistry. 2003, vol.54, p.57-87. In the device of Ehrler et al., infrared photons are absorbed using lead sulfide (PbS) nanocrystals. Visible photons are absorbed in pentacene to create singlet excitons, which undergo rapid exciton fission to produce pairs of triplets. Each of the two triplets can generate charge following dissociation at an organic/inorganic heterointerface meaning the direct effect of singlet fission in the solar cell is to double the photocurrent while halving the maximum possible photovoltage. WO 2014/052530 discloses a photovoltaic device comprising a light harvesting device comprising an organic semiconductor photoactive layer capable of multiple exciton generation with a luminescent material dispersed therein; a photovoltaic cell disposed in an emissive path of the luminescent material and having a first photoactive layer; wherein the bandgap of the luminescent material matches that of the first photoactive layer.

Accordingly, there is a need to further improve the coupling of organic and inorganic semiconductors and enable efficient energy transfer between them. Further there is a need to establish the conditions under which triplet excitons can undergo efficient energy transfer into inorganic semiconductors.

It is therefore an object of the present invention to provide a composite light harvesting material capable of coupling organic and inorganic semiconductors together using energy transfer of triplet excitons. The composite light harvesting material has applications in photovoltaics (PVs), light emitting-diodes, lasers and sensors.

According to a first aspect of the present invention, there is provided a photovoltaic device comprising a light harvesting device and a photovoltaic cell as claimed in claim 1.

In the following the inventors demonstrate that the triplet excitons can be transferred from the organic semiconductor to the luminescent material via Dexter energy transfer. The triplet excitons, formed as a result of multiple exciton generation in the organic semiconductor are transferred from the organic semiconductor to the luminescent material via non-radiative energy transfer.

According to a second aspect of the present invention, there is provided a composite material as claimed in claim 12.

In each aspect of the invention and the preferred embodiments described herein, bandgap is taken to mean that the triplet excitons are resonant with the lowest optical absorption band.

## Brief description of drawings

Embodiments of the invention will now be described, by way of example only, and with reference to the accompanying drawings of which:

FIGURE 1 is a schematic diagram of singlet fission down conversion;
FIGURE 2 is a schematic diagram of a device structure;
FIGURE 3 is a graph of external quantum efficiency of a device according to a first embodiment of the invention compared to various controls;
FIGURE 4a is a schematic diagram of singlet exciton fission in pentacene

FIGURE 4b is a schematic diagram to illustrate how inorganic solar cells can be singlet fission sensitized using triplet transfer from a thin organic singlet fission layer;

FIGURE 4c is a schematic diagram of possible processes a triplet exciton can undergo at an organic/inorganic interface;

FIGURE 4d is a graph comparing kinetics at a pentacene ground state in pristine pentacene and bilayers with lead selenide nanocrystals;

FIGURE 5a is a Transient Absorption spectra (TA) of pentacene with lead selenide bilayer, the data in FIGURE 5a is decomposed into three excited state species, with spectra shown by the solid lines in FIGURE 5b and corresponding population kinetics shown in FIGURE 5c;

FIGURE 5d illustrates blue-shifting of the Ground State Bleach (GSB) peaks of the lead selenide nanocrystals;

FIGURE 6a is a graph of normalized kinetics of a pentacene spectral component extracted via the GA from transient absoprtion data of pentacene and lead selenide bilayers with varying nanocrystal bandgaps;

FIGURE 6b is a graph of the corresponding PbSe spectral component of FIGURE 6a;

FIGURE 6c is a schematic diagram of the range of nanocrystal bandgaps for which triplet transfer was observed for a pentacene to lead selenide bilayer;

FIGURE 7a is a graph of photoluminescence of lead selenide, pentacene and lead selenide bilayer films;

FIGURE 7b is a graph showing photoluminescent enhancement from lead selenide is correlated to pentacence absorption; and

FIGURE 8 is a schematic diagram of a light emitting diode based upon triplet transfer to inorganic nanocrystals.

**Description of embodiments**

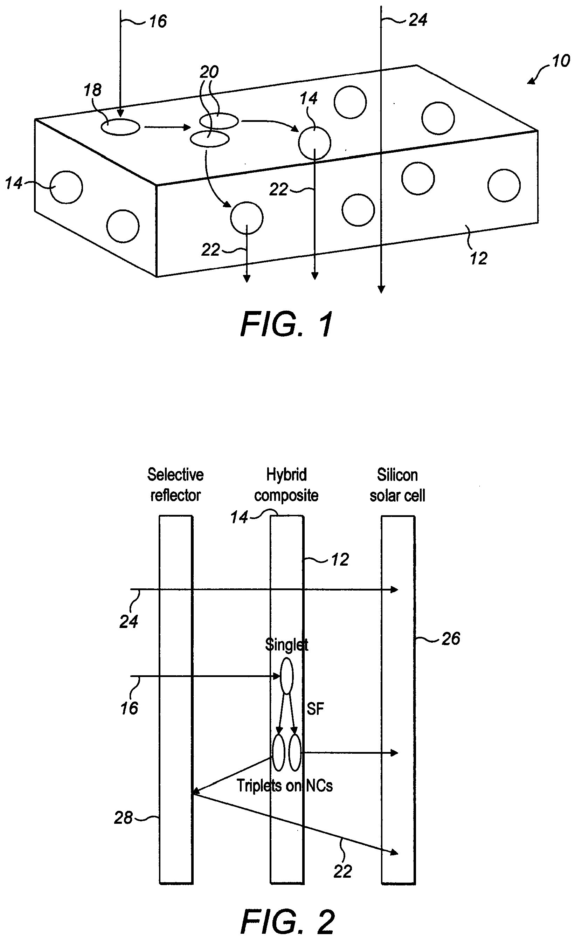

According to Figure 1 and first embodiment of the present invention, a composite material 10 comprises a thin film of an organic material 12 capable of singlet fission, mixed with inorganic nanocrystals 14. Light absorption of high-energy photons 16 in the organic material 12 creates singlet excitons 18 that rapidly undergo singlet fission to form two triplet excitons 20. The triplets excitons 20 cannot emit because of spin selection rules. However, the triplet excitons 20 will diffuse and undergo efficient Dexter energy transfer into the inorganic nanocrystals 14. The electron-hole pair in the inorganic nanocrystal 14 can then recombine radiatively, emitting a photon 22. Thus every high-energy photon 16 absorbed by the organic material 12 can lead to the emission of two low energy photons 22 by the nanocrystals 14. Low energy photons 24 pass through the organic material 12.

The photons 22 emitted by the nanocrystals 14 can be absorbed by an adjacent solar cell 26 such as presented in Figure 2. A light trapping layer 28 such as a selective reflector 28 can be used such that it reflects photons 22 emitted by the nanocrystals 14 to enhance light incoupling into the adjacent solar cell. This is a way of converting the energy from one high-energy photon 16 into two low-energy photons 22 that match the bandgap of the solar cell 26, hence doubling the current generated from high-energy photons 16.

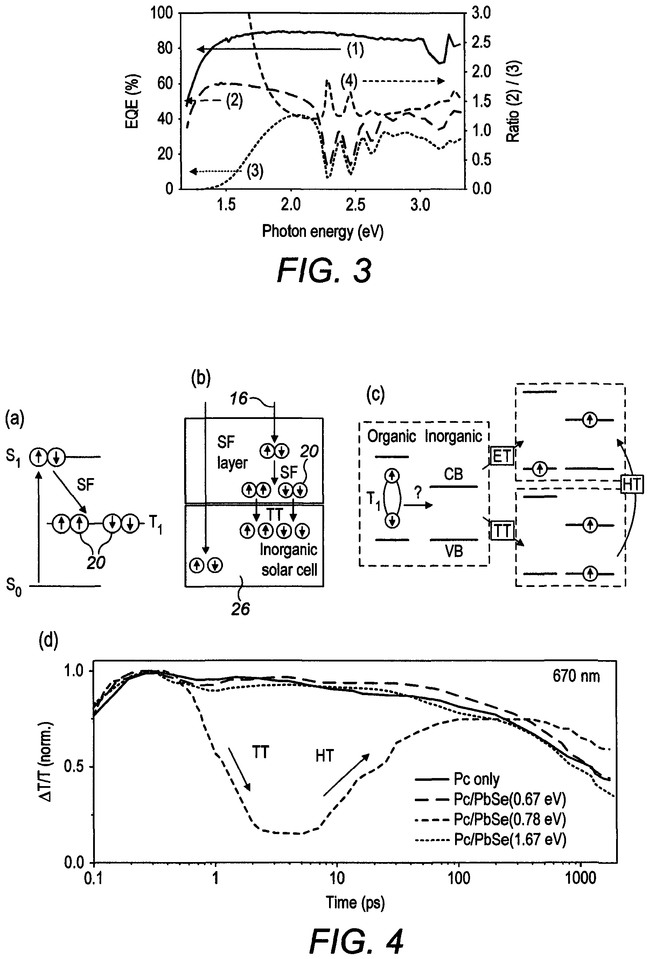

Referring to Figure 3, we exemplify the first embodiment of the present invention using TIPS-tetracene molecules. PbSe quantum dots of 1.1eV bandgap were embedded in the TIPS-Tetracene matrix (10% by weight) and the EQE of a silicon solar cell was observed. Trace 1 is external quantum efficiency of the silicon solar cell and trace 2 is a silicon solar cell with a film of composite material in the light path. Using a filter between the composite layer and the solar cell, low energy photons, including the photons emitted from the nanocrystals, can be filtered out (trace 3) and the ratio of traces 2 and 3 with and without a filter in trace 4 reveals that additional current generated by the nanocrystal emission in the infrared originates from absorption of the organic singlet fission sensitizer in the visible.

Trace 2 spectrum of Figure 3 shows a clear dip where the tetracene absorbs and when a filter to remove the light emitted from the nanocrystals is placed between the tetracene film and the silicon solar cell as shown in trace 3, the overall efficiency goes down. Crucially, it reduces more where the tetracene absorbs, identifying the additional current from the triplet transfer in trace 4.

Accordingly therefore in the first embodiment of the present invention, the inventors have demonstrated efficient resonant-energy transfer of molecular spin triplet excitons from organic semiconductors to inorganic semiconductors. In the following description, we further demonstrate the physical process behind the transfer using ultrafast optical absorption spectroscopy to track the dynamics of triplets, generated in pentacene via singlet exciton fission, at the interface with lead selenide (PbSe) nanocrystals. We show that triplets transfer to PbSe rapidly (<1ps) and efficiently, with 1.8 triplets transferred for every photon absorbed in pentacene. The triplet transfer is most efficient when the bandgap of the nanocrystals is close to resonance ($\pm 0.2$ eV) with the triplet energy. Following triplet transfer, the excitation can undergo either charge separation, allowing photovoltaic operation, or radiative recombination in the nanocrystal, enabling luminescent harvesting of triplet exciton energy in light emitting structures.

EXAMPLE

Singlet exciton fission (SF) is a process in organic semiconductors, by which a single photogenerated spin-singlet exciton is converted to two spin-triplet excitons on nearby chromophores. As the process is spin allowed, it can occur on sub 100 fs timescales with an efficiency of 200 %, when the energetics of the system are favourable, i.e. the energy of the spin-singlet exciton is greater than or equal to twice the energy of the spin-triplet exciton. SF is a promising route to overcome the Shockley-Queisser limit in single-junction photovoltaics, if a SF material could be suitably combined with a low-bandgap inorganic semiconductor.

Therefore referring to Figure 4a, singlet exciton fission in pentacene is demonstrated schematically wherein photogenerated singlet excitons $S_1$ undergo singlet fission SF into two triplet excitons 20 with a time $T_1$ of within 80fs.

In this configuration, illustrated in Figure 4b, the low-bandgap semiconductor 26 generates one electron-hole pair for each low-energy photon 24 absorbed, while the SF material 12 generates two triplet excitons 20 for each high-energy photon 16 absorbed. By distributing the energy of high-energy photons 16 into two excitations, SF could allow solar cells to overcome the otherwise dominant thermalisation losses. Ideally, the energy of the triplet excitons 20 could be directly transferred into the inorganic semiconductor 26, for which charge generation and collection are already optimized. This approach allows the SF material to act as an energy-funnelling layer on top of a conventional photovoltaic cell, rather than being an active part of the circuit.

Pentacene (Pc) is a model system for singlet exciton fission. Previous transient optical absorption (TA) measurements on Pc determined a fission rate of 80 fs, outcompeting alternative decay mechanisms. The fission-generated triplets can be efficiently dissociated at a heterojunction using the fullerene C60 as the acceptor, allowing for external quantum efficiencies (EQE) of 126 %, the highest for any photovoltaic technology to date. There are two possible pathways for charge generation at such organic/inorganic interfaces, as shown in Figure 4c. The first is electron transfer (ET) from Pc to PbSe. The second is energy transfer of triplet excitons (triplet transfer TT) into PbSe, followed by back-transfer of holes (hole transfer HT) into Pc to obtain charge separation.

RESULTS

To investigate the dynamics of Pc triplet excitons at the interface with PbSe, the inventors performed TA measurements on thin PbSe/Pc bilayers, consisting of 1-2 monolayers of spin-coated PbSe, onto which 5nm of Pc (3 molecular layers) was evaporated. The thinness of the pentacene layer ensures that all triplet excitons are generated close to the interface with PbSe. This allows the inventors to probe interfacial dynamics, which are normally masked by bulk diffusion processes. The samples were investigated with femtosecond (fs) TA spectroscopy, using a narrowband pump pulse centred at 550 nm and broadband probe pulses. In order to amplify the signal from the extremely thin layers, we use an optical cavity, which allows for multiple passes of collinear pump and probe beams through the sample. A series of PbSe nanocrystals with bandgap energies between 0.67 and 1.61 eV were compared against Pc.

Figure 4d compares the TA kinetics, at 670 nm, in pristine Pc and Pc/PbSe bilayers with nanocrystals of varying bandgap. 670 nm is the position of the peak of the Pc ground state bleach (GSB). The lowest lying molecular triplet exciton (T1) in Pc has been reported to lie close to 0.86 eV. The two bilayers with nanocrystals of bandgap far below (0.67 eV) and above (1.61 eV) this energy, show almost identical kinetics to the pristine Pc film. In contrast, the bilayer with nanocrystals of bandgap 0.78 eV, which is close to resonance with T1, shows a significant drop in signal within the first 2 ps followed by a revival at later times. As we develop below, this kinetic behaviour is due to energy transfer, de-exciting the chromophore, followed by back charge transfer, re-exciting the chromophore.

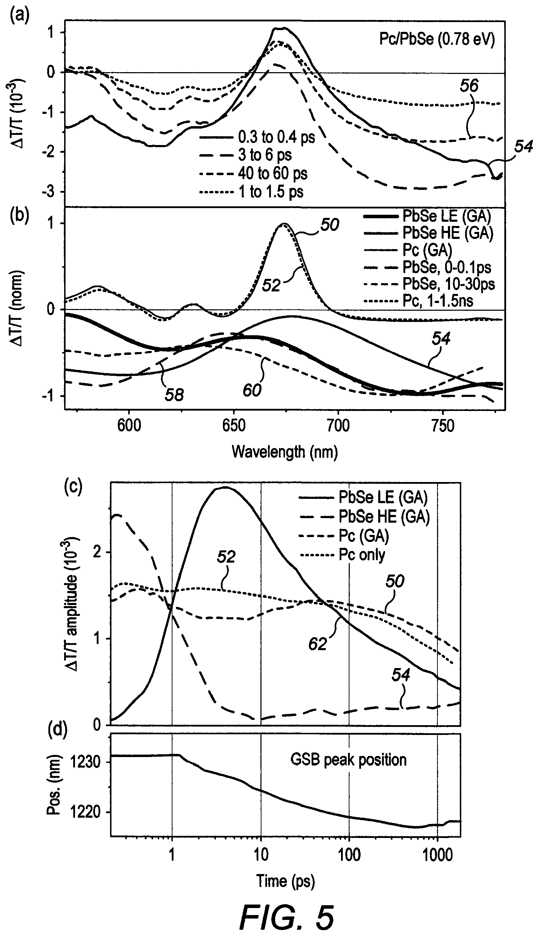

However, the presence of excited state signals from the PbSe also needs to be taken into account, before we can quantify the populations of excited state species. Figure 5a shows TA spectra of the Pc/PbSe (0.78 eV) bilayer. In order to extract the individual spectra and population kinetics of the various excited state species we use a genetic algorithm. The data in Figure 5a can be decomposed into three excited state species, with spectra shown by the solid lines in Figure 5b and corresponding population kinetics shown in Figure 5c. One component 50 matches the signal expected for Pc, as demonstrated by the agreement with the spectrum of a pristine Pc film (dashed spectra 52). We note that after the ultrafast fission process (80 fs), there is no spectral evolution in the signal from Pc. Thus, in the experiments presented here, with a time resolution >300fs, only a single spectrum is expected for Pc. The nanocrystals show two distinct spectra in this region (solid 54, 56), associated with relaxation from higher to lower energy excited states, as demonstrated by the early and later time signals from pristine PbSe films (dashed spectra 58, 60).

We now turn to the kinetics extracted by the genetic algorithm, shown in Figure 5c, which represent the weight of the spectral component of an excited state species in the whole data set, rather than kinetics at a particular spectral point. We observe that the Pc component in the Pc/PbSe(0.78 eV) film (50) drops faster than in pristine Pc films (dashed 52), over the initial 0.3-3 ps, but subsequently rebounds, and at later times (>30 ps) has a larger signal than pristine Pc films. The population in the Pc, at the earliest times we can observe (300 fs) consists entirely of triplet excitons, due to the ultrafast (80 fs) fission process. Thus the reduction in signal between 0.2-3 ps represents a loss of triplet excitons. The increase in signal at later times is consistent with hole-transfer from the PbSe to Pc. The rise of the lower-energy excited state component of PbSe, curve 62 is associated with the reduction of the higher-energy PbSe excited state component (curve 54), as well as the loss of triplets in Pc. This suggests that both processes could populate the lower-energy PbSe excited state.

Lastly, we observe a blue-shifting in the GSB peaks of the PbSe nanocrystals, figure 5d. We consider this shift to be caused by charge transfer across the Pc/PbSe interface, which sets up microscopic electric fields, causing a Stark shift of the transition energy of species near the interface. This result in a derivative-like feature at the red-edge of the absorption feature, termed electroabsorption. The blue-shift of the GSB occurs over tens of ps, and hence, the associated charge-transfer process occurs over tens of ps. This timescale is consistent with the rebound in the Pc component, confirming the assignment of this rise to hole back transfer from the PbSe. No electroabsorption features or shifts in GSB were observed for pristine PbSe layers or Pc/PbSe bilayers in which the triplet transfer was not observed. Thus, the model that emerges from the data is one of forward triplet transfer from Pc to PbSe followed by back hole transfer from PbSe to Pc.

Therefore as illustrated at Figure 5a, we show transient absorption (TA) spectra of Pc/PbSe (0.78eV) films. Spectra are averaged over the indicated pump-probe delays. The pump fluence is $30 \mu Jcm^{-2}$ for the first pass and $0.4 \mu Jcm^{-2}$ for the last pass. The TA data can be numerically decomposed into 5 components using a genetic algorithm (GA) and are shown in Figures 5a to d.

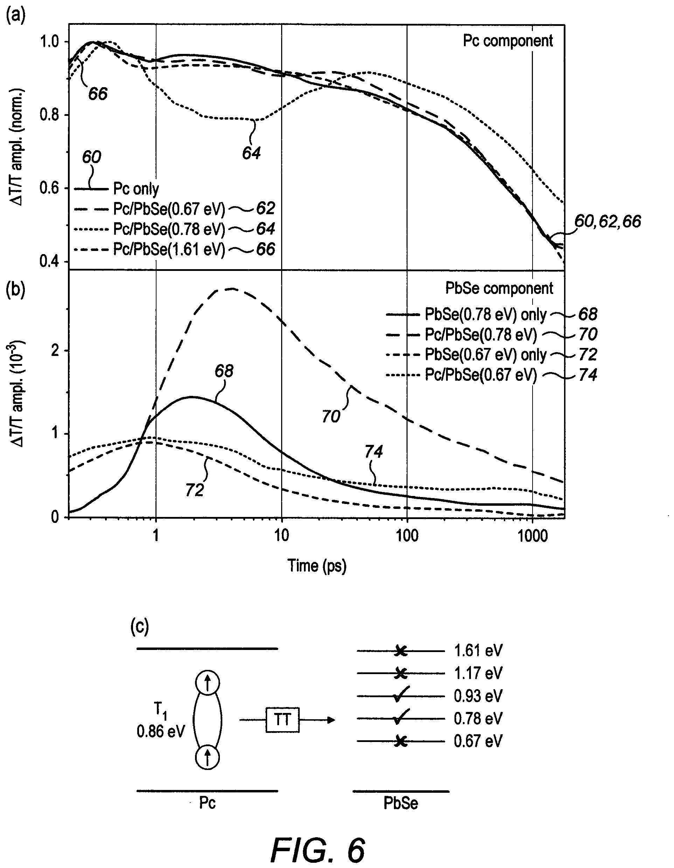

Figure 6a shows normalized kinetics, extracted via the GA, of the Pc component in both pristine a Pc film and Pc/PbSe bilayers with varying nanocrystal bandgaps. Figure 6b shows the corresponding PbSe component in both pristine nanocrystal films and Pc/PbSe bilayers. The initial triplet transfer and subsequent hole transfer are observed only with nanocrystal bandgap of 0.78 eV, Figure 6a. In the other two cases, for nanocrystals of bandgap much higher or lower than the Pc triplet energy (0.86 eV), the kinetics are almost identical to pristine pentacene films, indicting very little or no triplet transfer.

Turning to the PbSe component, Figure 6b, for the 0.67 eV nanocrystals, where no triplet transfer is observed, there is only a small difference between pristine PbSe (dashed 72) and Pc/PbSe (solid 74). However, for the 0.78 eV nanocrystals, where triplet transfer is observed, there is a large enhancement in signal for the Pc/PbSe sample (solid 70) in comparison to the pristine PbSe (dashed 68). The signal peaks at a later time, 4-5 ps, consistent with the timescale for triplet transfer (Figure 6a). This shows that the increase in signal is due to transfer of triplets to the PbSe. The population is also found to be longer-lived, consistent with the formation of longer-lived charges following back hole transfer. In summary, inFigure 6c, we find that triplet transfer (TT) from Pc occurs most efficiently in nanocrystals with bandgap of 0.78eV or 0.93eV. Nanocrystals whose bandgap lie within a narrow range (less than $\pm 0.2$ eV) of the Pc triplet energy (0.86 eV) show the most efficient triplet transfer.

The narrow energy range in which triplet transfer most efficiently occurs indicates the importance of the overlap of the density of states of donor and acceptor.

The coupling integral for the energy transfer process contains contributions both from the Coulomb interaction and exchange interaction. The negligible oscillator strength of the S0→T1 transition for Pc means that the Coulomb interaction plays no significant role in the process. For the exchange interaction, DEXTER, D. L. A Theory of Sensitized Luminescence in Solids. The Journal of Chemical Physics. 1953. derived that:

$$k \approx e^{-\frac{2R}{L}} J$$

where, k is the rate of transfer, L is the orbital radius of donor and acceptors site, R is the separation between them and J is the normalised spectral overlap between donor emission and acceptor absorption.

Importantly, J is independent of the oscillator strengths of the optical transitions. Thus, triplet transfer would only be efficient to nanocrystals whose lowest-energy absorption feature, which has a large density of states, overlapped with the S0→T1 transition for Pc, at about 0.8 eV. The width of the lowest-energy absorption feature for the nanocrystal studied here is about 0.15 eV which corresponds well with the narrow range in which triplet transfer is observed, less than $\pm 0.2$ eV.

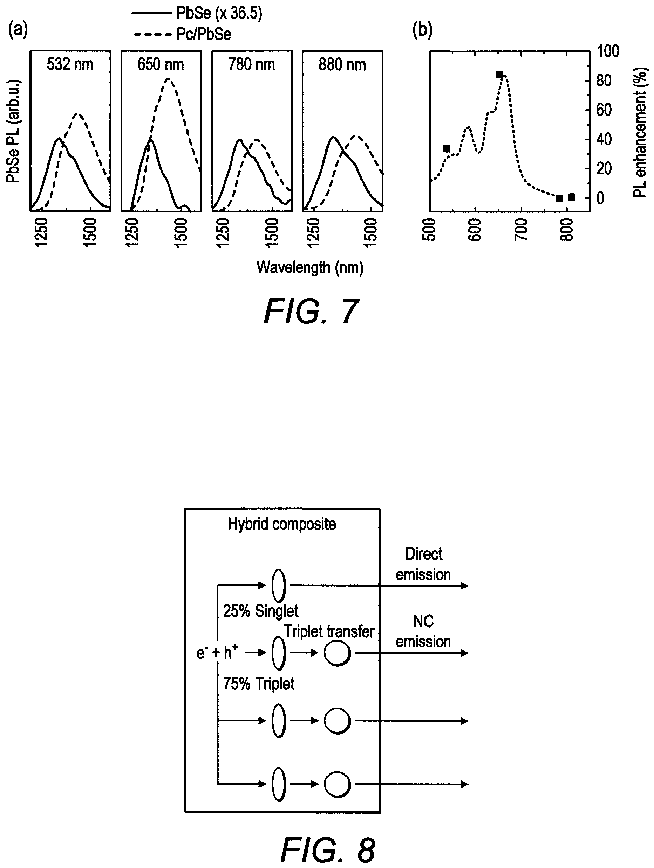

For the Pc/PbSe system studied here, triplet transfer can be followed by back hole transfer. But a fraction of the excitations may not undergo hole-transfer and recombine within the PbSe. Also at later times electron-hole recombination, of states previously separated across the interface, will occur. Both cases allow for radiative recombination and hence enhanced emission from the PbSe, whenever triplet transfer is possible. Figure 7a shows the PL spectra, for PbSe and Pc/PbSe films, for excitation above (532 and 650 nm) and below (780 and 808 nm) the Pc bandgap. The red-shift of the PL peaks in the bilayer results from a red-shift in the absorption onset of the PbSe in Pc/PbSe films in comparison to pristine PbSe films. In all cases the Pc/PbSe shows enhanced PL in comparison to pristine PbSe. We consider the enhanced PL for below gap excitation (780 and 808 nm) to arise from increased radiative recombination in the presence of Pc, due to a change in the local environment of the PbSe. We normalize the PL signals using the ratio of the PL of Pc/PbSe to PbSe at 808 nm (factor of 36.5). This allows us to account for the increased radiative recombination, which should be independent of pump wavelength, and isolate enhanced PL arising from triple transfer. Following normalisation, no change in relative PL is seen at 780 nm, but much stronger PL is seen at 650 and 532 nm.

As shown in Figure 7b, the stronger PL is correlated to the Pc absorption, confirming that it arises due to triplet energy transfer from the Pc. Near the peak of the Pc absorption, at 650nm, the Pc/PbSe (0.93 eV) bilayer absorbs 47% more light than the PbSe (0.93 eV) film (see S10). Crucially, at this wavelength the PL is enhanced by 85%. This means that for every photon absorbed by Pc 1.8 excitations contribute to the PL. As shown above, triplet transfer is the dominant process in the bilayers. Assuming that singlet fission proceeds with a 200% yield of triplets, this implies a minimum triplet transfer efficiency of 90%. No PL enhancement arising due to excitation of Pc was observed for Pc/PbSe samples where the nanocrystal bandgap blocked triplet transfer, which further demonstrates the enhancement does not arise from early time (sub 100 fs) transfer of singlet excitons via FRET. We note, that by suitable choice of SF material and inorganic acceptor, it would be possible to arrange energetics such that back hole transfer is blocked, allowing only for triplet transfer.

In conclusion, we have reported the first demonstration of triplet energy transfer from organic to inorganic semiconductors. Our studies of the photophysics of thin bilayer samples of pentacene/PbSe nanocrystals demonstrate that triplet energy transfer from pentacene to PbSe is efficient only when the nanocrystal bandgap is resonant with the molecular triplet energy. This result opens new avenues to couple organic and inorganic semiconductors and new possibilities for devices. For instance, to harness non-radiative triplet excitons generated via electrical injection of charges in to organic LEDs. The triplets could be harvested via transfer into inorganic nanocrystals where the electron-hole pair could recombine radiatively, allowing for white-light emission without the need for phosphorescent molecules. As demonstrated here, this process can also be used to harness triplet excitons generated via singlet exciton fission, allowing the energy of the triplets to be directly funnelled in to conventional inorganic solar cells. This offers a very promising method to overcome the Shockley-Queisser limit.

METHODS

Nanocrystal fabrication: All chemicals were purchased from Sigma Aldrich, if not stated otherwise, and were anhydrous if available. PbSe nanocrystals were synthesized following standard methods20. Briefly, Pb(OAc)2H2O (3.44 mmol;1.3 g), oleic acid (OA; 8.58 mmol; 2.7 ml) and 1octadecene (ODE; 75 mmol; 24 ml) were degassed at 100 °C under vacuum (10 - 2 mbar or better) for 2 h. In order to form the Pb-oleate precursor complex the temperature was raised to 160 °C under nitrogen atmosphere and subsequently changed to the desired Se-precursor injection temperature (120°C - 180°C). In parallel, Se (Alfa Aeser, 10.8 mmol; 852.8 mg), diphenylphosphine (DPP; 15 $\mu$mol; 26.1 $\mu$l) and trinoctylphosphine (TOP; 24.2 mmol; 10.8 ml) were combined and stirred under nitrogen atmosphere to form the Se-precursor. PbSe nanocrystal growth was initiated by the rapid injection of the Se-precoursor into the prepared Pb-oleate solution. After the desired nanocrystal size was reached (20sec - 5min) the reaction was quenched by injecting 20ml of hexane and by placing the flask into an ice-cooled water bath. Subsequent purification steps were carried out in an argonfilled glovebox. The nanocrystals were extracted via repeated precipitation with a mixture of 1-butanol and ethanol.

Sample Fabrication: Samples were fabricated on 0.13 mm thin cover glass slides. Nanocrystal films were deposited by a layer-by-layer method, in an inert environment, using 1,3-benzenedithiol as a crosslinking molecule, from a 5mg/mL solution of PbSe. Subsequently, 5 nm of pentacene was evaporated on the nanocrystal films, in a vacuum better than 2x10-6 mbar. The samples were encapsulated with a second 0.13 mm thin glass slide and an epoxy glue before exposing to air.

Steady State Optical Measurements: The absorption spectra of the nanocrystals were taken in solution at 0.05-1 mg/mL using a PerkinElmer Lambda 9 UV VisIR spectrophotometer. PL was measured by illuminating a spot of ca. 2mm in diameter with a diode lasers (MGL-III-532 for 532 nm, SMFR-R0004 for 650 nm, Lasermax-MDL for 780 nm, IQu1C135 for 808 nm). Lenses project the PL emitted to a solid angle of $0.1\pi$ onto an InGaAs detector (Andor DU490A-1.7) which has a cut-off at 1600 nm.

Transient absorption (TA) spectroscopy: In this technique a pump pulse generates photoexcitations within the film, which are then studied at some later time using a broadband probe pulse. A portion of the output of a Ti:Sapphire amplifier system (Spectra-Physics Solstice) operating at 1 KHz, was used to pump a TOPAS optical parametric amplifier (Light Conversion), to generate narrowband (10nm FWHM) pump pulses centered at 550nm. Another portion of the amplifier output was used to pump a home built non-collinear optical parametric amplifier (NOPA). The probe beam was split to generate a reference beam so that laser fluctuations could be normalized. Pump and probe beams were made collinear with a beam splitter and entered an optical cavity, consisting of two concave mirrors (focal length f) placed 4f apart from each other with the sample in the center. The beams underwent multiple bounces in the cavity, making multiple passes in the sample, thus allowing for the weak signal from the thin layers to be amplified. After exiting the cavity a long pass filter was used to block the pump beam, while allowing the probe beam to pass. The probe and reference beams were dispersed in a spectrometer (Andor, Shamrock SR-303i) and detected using a pair of 16-bit 512-pixel linear image sensors (Hamamatsu). The probe was delayed using a mechanical delay stage (Newport) and every second pump pulse was omitted using a mechanical chopper. Data acquisition at 1 kHz was enabled by a custom-built board from Stresing Entwicklunsbüro. The differential transmission ($\Delta T/T$) was calculated after accumulating and averaging 1000 "pump on" and "pump off" shots for each data point.

Due to the group velocity mismatch between pump and probe wavelengths there is a reduction in time resolution of the experiment. From the rise time of the signal we estimate the time resolution of the experiment to be about 300fs at 670nm. While this is insufficient to study the initial singlet fission process in Pc, which proceeds on sub 100fs timescales, it is sufficient to study the triplet transfer process.

Numerical Methods: We use numerical methods based on a genetic algorithm to deconvolute the overlapping spectral signatures of individual excited states and obtain their kinetics. In summary, a large population of random spectra are generated and bred to form successive generations of offspring, using a survival of the fittest approach. The best spectra are returned as optimized solutions. For a given solution, the fitness is calculated as the inverse of the sum of squared residual with a penalty added for non-physical results. The parent spectra are selected using a tournament method with adaptive crossover. The offspring are generated using a Gaussian-function mask of random parameters

According to a third embodiment of the present invention, in organic light-emitting diodes, excitons are generated from charges, electrically injected into the active layer. These charges (electrons, e-, and holes, h+) form only 25% of the emissive singlet excitons and 75% of the non-emissive triplet excitons. Hence, without phosphorescence, only 25% of the charges can be converted into light. With a small fraction of nanocrystals in the active layer, those triplets can be converted into an emissive species and generate additional light as illustrated in Figure 8. Also, such an LED would emit at two different wavelengths, opening the possibility for white-light emission from a single layer of composite material.

## Claims

1. A photovoltaic device comprising a light harvesting device and a photovoltaic cell; wherein the light harvesting device comprises an organic semiconductor photoactive layer capable of multiple exciton generation with a luminescent material dispersed therein; wherein the bandgap of the luminescent material is selected such that the triplet excitons, formed as a result from the multiple exciton generation in the organic semiconductor, can be transferred into the luminescent material non-radiatively via Dexter Energy Transfer; a photovoltaic cell disposed in an emissive light path of the luminescent material and having a first photoactive layer, wherein the bandgap of the luminescent material matches or is higher than the bandgap of the first photoactive layer; **characterised in that** the luminescent material comprises an inorganic nanocrystal semiconductor passivated with ligands that solubilise the nanocrystal semiconductor in solvents compatible with the organic semiconductor.

2. A photovoltaic device as claimed in claim 1, wherein the organic semiconductor photoactive layer is capable of singlet exciton fission.

3. A photovoltaic device as claimed in claim 2, wherein the organic semiconductor is an oligoacene, the oligoacene is pentacene, tetracene or derivatives thereof optionally selected from bis(triisopropyl-silylethynyl) pentacene (TIPS-P), diphenylpentacene (DPP), di-biphenyl-4-yl-pentacene (DBP), di(2'-thienyl)pentacene (DTP), and di-benzothiophene-pentacene (DBTP), bis(triisopropylsilylethynyl) pentacene (TIPS-P), bis((triethyl)ethynyl)pentacene (TES-P) or rubrene, bis(trisopropyl-silylethynyl) tetracene (TIPS-T), di(2'-thienyl)tetracene (DTT).

4. A photovoltaic device as claimed in any preceding claim, wherein the organic semiconductor photoactive layer has a bandgap in the range 2.0 to 3.0 eV, preferably 2.2 to 2.5eV, more preferably 2.4eV.

5. A photovoltaic device as claims in any preceding claim, wherein the bandgap of the luminescent material is within 0.4eV of the bandgap of the energy of the triplet excitons, preferably within 0.3eV, more preferably within 0.2eV.

6. A photovoltaic device as claimed in any preceding claim, wherein the bandgap of the luminescent material is in the range of 0.6eV to 1.6eV, preferably 0.75eV to 1.3eV, more preferably 0.95eV to 1.2eV.

7. A photovoltaic device as claimed in claim 1, wherein the nanocrystal semiconductor comprises any one or more of nanocrystals comprising a lead chalcogenide nanocrystal, CdSe, CdS, ZnTe, ZnSe, PbS, PbSe, PbTe, HgS, HgSe, HgTe, HgCdTe, CdTe, CZTS, ZnS, CuInS2, CuInGaSe, CuInGaS, Si, InAs, InP, InSb, SnS2, CuS, Ge, and Fe2S3.

8. A photovoltaic device as claimed in any preceding claim, where the mean distance between the luminescent components is chosen to be similar to the triplet exciton diffusion length in the organic semiconductor; where a low concentration of the luminescent component is necessary to minimise self-absorption by the luminescent component.

9. A photovoltaic device as claimed in any preceding claim, where the mean distance between the luminescent components is between 10 nm and 2000 nm, more preferably between 20 nm and 200 nm.

10. A photovoltaic device as claimed in any preceding claim, wherein the photovoltaic cell is provided with the first photoactive layer comprising silicon.

11. A photovoltaic device as claimed in any of claims 1 to 10, wherein the photovoltaic cell is provided with the first photoactive layer comprising crystalline silicon, amorphous silicon, copper indium gallium selenide (CIGS), germanium, CdTe, GaAs, InGaAs, In-

GaP, InP, quantum dot, metal oxide, organic polymer or small molecule or perovskite semconductors such as organometal halide perovksite semiconductors and more specifically methylammonium lead iodide chloride (CH3NH3PbI2Cl).

12. A composite material comprising a host organic semiconductor material capable of multiple exciton generation dispersed with a luminescent material; wherein the bandgap of the luminescent material matches the energy of the triplet excitons formed as a result from the multiple exciton generation so that the triplet excitons are resonant with the bandgap of the luminescent material and the triplets can be transferred into the luminescent material non-radiatively via Dexter Energy Transfer; the luminescent material being capable of light emission; **characterised in that** the luminescent material comprises an inorganic nanocrystal semiconductor passivated with ligands that solubilise the nanocrystal semiconductor in solvents compatible with the organic semiconductor.

13. A photon multiplier system comprising a film and containing the composite material of claim 12 further provided with at least one light-directing element to preferentially direct light emitted from the luminescent material towards one or a selection of the surfaces or edges.

14. A photovoltaic device as claimed in claims 1 to 11; wherein the light harvesting device comprises an organic semiconductor photoactive layer capable of multiple exciton generation with luminescent nanocrystals dispersed therein; wherein the bandgap of the nanocrystals is selected such that the triplet excitons, formed as a result from the multiple exciton generation in the organic semiconductor, can be transferred into the nanocrystals, where the last energy transfer step into the nanocrystals is mediated by non-radiative Dexter Energy Transfer.

15. A photovoltaic device as claimed in claims 1-11, wherein the nanocrystal semiconductor comprises any one or more of nanocrystals comprising organometal halide perovskite or cesium lead halide perovskite.

**Patentansprüche**

1. Photovoltaische Vorrichtung, umfassend eine Lichtentnahmevorrichtung und einer photovoltaischen Zelle; wobei die Lichtentnahmevorrichtung eine photoaktive Schicht aus einem organischen Halbleiter aufweist, die in der Lage ist, vielfache Exzitonen mit einem darin dispergierten lumineszierenden Material zu erzeugen; wobei die Bandlücke des lumineszierenden Materials gewählt ist, sodass die Triplett-Exzitonen, die als Resultat der Erzeugung vielfacher Exzitonen in dem organischen Halbleiter gebildet werden, in das lumineszierende Material strahlungsfrei über Dexter-Energieübertragung übertragen werden können; eine photovoltaische Zelle, angeordnet in einem emittierenden Lichtweg des lumineszierenden Materials und die eine erste photoaktive Schicht aufweist, wobei die Bandlücke des lumineszierenden Materials mit der Bandlücke der ersten photoaktiven Schicht übereinstimmt oder höher als diese ist; **dadurch gekennzeichnet, dass** das lumineszierende Material einen anorganischen nanokristallinen Halbleiter umfasst, der mit Liganden passiviert ist, die den nanokristallinen Halbleiter in Lösungsmitteln lösen, die mit dem organischen Halbleiter kompatibel sind.

2. Photovoltaische Vorrichtung nach Anspruch 1, wobei die organische photoaktive Halbleiterschicht zu Singulett-Exzitonen-Spaltung in der Lage ist.

3. Photovoltaische Vorrichtung nach Anspruch 2, wobei der organische Halbleiter ein Oligoacen ist, das Oligoacen Pentacen, Tetracen oder Derivate davon ist, optional ausgewählt aus bis(Triisopropyl-silylethynyl)pentacen (TIPS-P), Diphenylpentacen (DPP), di-Biphenyl-4-yl-pentacen (DBP), Di(2'-thienyl)pentacen (DTP) und di-Benzothiophenpentacen (DBTP), bis(Triisopropyl-silylethynyl)pentacen (TIPS-P), bis((Triethyl)ethynyl)pentacen (TES-P) oder Rubren, bis(trisopropyl-silylethynyl)tetracen (TIPS-T), di(2'-Thienyl)tetracen (DTT).

4. Photovoltaische Vorrichtung nach einem der vorherigen Ansprüche, wobei die organische photoaktive Halbleiterschicht eine Bandlücke im Bereich von 2,0 bis 3,0 eV, vorzugsweise 2,2 bis 2,5 eV, noch bevorzugter 2,4 eV, aufweist.

5. Photovoltaische Vorrichtung nach einem der vorherigen Ansprüche, wobei die Bandlücke des lumineszierenden Materials innerhalb von 0,4 eV der Bandlücke der Energie der Triplett-Exzitonen ist, vorzugsweise innerhalb von 0,3 eV, noch bevorzugter innerhalb von 0,2 eV.

6. Photovoltaische Vorrichtung nach einem der vorherigen Ansprüche, wobei die Bandlücke des lumineszierenden Materials im Bereich von 0,6eV bis 1,6eV, vorzugsweise 0,75eV bis 1,3eV, noch bevorzugter 0,95eV bis 1,2eV ist.

7. Photovoltaische Vorrichtung nach Anspruch 1, wobei der Nanokristall-Halbleiter einen oder mehrere Nanokristalle umfasst, umfassend einen Bleichalcogenid-Nanokristall, CdSe, CdS, ZnTe, ZnSe, PbS, PbSe, PbTe, HgS, HgSe, HgTe, HgCdTe, CdTe, CZTS, ZnS, CuInS2, CuInGaSe, CuInGaS, Si, InAs, InP, InSb, SnS2, CuS, Ge und Fe2S3.

8. Photovoltaische Vorrichtung nach einem der vorherigen Ansprüche, wobei der mittlere Abstand zwischen den lumineszierenden Komponenten gewählt ist, sodass er ähnlich wie die Triplett-Exziton-Diffusionslänge in dem organischen Halbleiter ist; wobei eine niedrige Konzentration der lumineszierenden Komponente notwendig ist, um eine Selbstabsorption durch die lumineszierende Komponente zu minimieren.

9. Photovoltaische Vorrichtung nach einem der vorherigen Ansprüche, wobei der mittlere Abstand zwischen den lumineszierenden Komponenten zwischen 10 nm und 2000 nm, vorzugsweise zwischen 20 nm und 200 nm, ist.

10. Photovoltaische Vorrichtung nach einem vorherigen Anspruch, wobei die photovoltaische Zelle mit der ersten photoaktiven Schicht umfassend Silizium versehen ist.

11. Photovoltaische Vorrichtung nach einem der Ansprüche 1 bis 10, wobei die photovoltaische Zelle mit der ersten photoaktiven Schicht umfassend kristallines Silizium, amorphes Silizium, Kupfer-Indium-Gallium-Selenid (CIGS), Germanium, CdTe, GaAs, InGaAs, InGaP, InP, Quantenpunkt, Metalloxid, organisches Polymer oder kleine Molekül- oder Perowskit-Halbleiter, wie z. B. Organometallhalogenidperowskit-Halbleiter und insbesondere Methylammonium-Bleijodidchlorid (CH3NH3PbI2Cl) versehen ist.

12. Verbundwerkstoff umfassend ein organisches Wirtshalbleitermaterial, das in der Lage ist, vielfache Exzitonen zu erzeugen, die mit einem lumineszierenden Material dispergiert sind; wobei die Bandlücke des lumineszierenden Materials mit der Energie der Triplett-Exzitonen übereinstimmt, die als Resultat der Erzeugung mehrerer Exzitonen gebildet werden, sodass die Triplett-Exzitonen mit der Bandlücke des lumineszierenden Materials resonant sind und die Tripletts über Dexter-Energieübertragung strahlungsfrei in das lumineszierende Material übertragen werden können; wobei das lumineszierende Material zur Lichtemission in der Lage ist; **dadurch gekennzeichnet, dass** das lumineszierende Material einen anorganischen Nanokristall-Halbleiter umfasst, der mit Liganden passiviert ist, die den Nanokristall-Halbleiter in Lösungsmitteln lösen, die mit dem organischen Halbleiter kompatibel sind.

13. Photonenvervielfacher-System, das einen Film umfasst und das Verbundmaterial nach Anspruch 12 enthält, ferner versehen mit mindestens einem lichtleitenden Element, um das von dem lumineszierenden Material emittierte Licht vorzugsweise auf eine oder eine Auswahl der Oberflächen oder Kanten zu leiten.

14. Photovoltaische Vorrichtung nach den Ansprüchen 1 bis 11; wobei die Lichtentnahmevorrichtung eine organische photoaktive Halbleiterschicht umfasst, die in der Lage ist, vielfache Exzitonen mit darin dispergierten lumineszierenden Nanokristallen zu erzeugen; wobei die Bandlücke der Nanokristalle gewählt ist, sodass die Triplett-Exzitonen, die als Resultat der Erzeugung vielfacher Exzitonen in dem organischen Halbleiter gebildet werden, in die Nanokristalle übertragen werden können, wobei der letzte Energieübertragungsschritt in die Nanokristalle durch strahlungsfreien Dexter-Energietransfer vermittelt wird.

15. Photovoltaische Vorrichtung nach Anspruch 1-11, wobei der Nanokristall-Halbleiter eines oder mehrere von Nanokristalle umfassend Organometallhalogenidperowskit oder Cäsiumbleihalogenidperowskit umfasst.

**Revendications**

1. Dispositif photovoltaïque comprenant un dispositif de récupération de lumière et une cellule photovoltaïque ; dans lequel le dispositif de récupération de lumière comprend une couche photoactive semi-conductrice organique capable de génération multiple d'excitons avec un matériau luminescent dispersé à l'intérieur de celle-ci ; dans lequel la bande interdite du matériau luminescent est sélectionnée de telle sorte que les excitons triplets, formés en résultat de la génération multiple d'excitons dans le semi-conducteur organique, puissent être transférés dans le matériau luminescent sans rayonnement via un transfert d'énergie selon Dexter ; une cellule photovoltaïque disposée dans un trajet lumineux émissif du matériau luminescent et ayant une première couche photoactive, dans lequel la bande interdite du matériau luminescent correspond ou est supérieure à la bande interdite de la première couche photoactive ; **caractérisé en ce que** le matériau luminescent comprend un semi-conducteur nanocristal inorganique passivé avec des ligands qui solubilisent le semi-conducteur nanocristal dans des solvants compatibles avec le semi-conducteur organique.

2. Dispositif photovoltaïque selon la revendication 1, dans lequel la couche photoactive semi-conductrice organique est capable de fission des excitons singulets.

**3.** Dispositif photovoltaïque selon la revendication 2, dans lequel le semi-conducteur organique est un oligoacène, l'oligoacène est le pentacène, le tétracène ou leurs dérivés éventuellement choisis parmi le bis(triisopropyl-silyléthynyl) pentacène (TIPS-P), diphénylpentacène (DPP), di-biphényle-4-yl-pentacène (DBP), di(2'-thiényl)pentacène (DTP) et di-benzothiophène-pentacène (DBTP), bis(triisopropylsilyléthynyl) pentacène (TIPS-P), bis((triéthyl)éthynyl)pentacène (TES-P) ou rubrène, bis(trisopropylsilyléthynyl) tétracène (TIPS-T), di(2'-thiényl) tétracène (DTT).

**4.** Dispositif photovoltaïque selon l'une quelconque revendication précédente, dans lequel la couche photoactive semi-conductrice organique a une bande interdite dans la plage de 2,0 à 3,0 eV, de préférence de 2,2 à 2,5 eV, plus préférablement de 2,4 eV.

**5.** Dispositif photovoltaïque selon l'une quelconque revendication précédente, dans lequel la bande interdite du matériau luminescent est à moins de 0,4 eV de la bande interdite de l'énergie des excitons triplets, de préférence à 0,3 eV, plus préférablement à 0,2 eV.

**6.** Dispositif photovoltaïque selon l'une quelconque des revendications précédentes, dans lequel la bande interdite du matériau luminescent se situe dans la plage de 0,6 eV à 1,6 eV, de préférence de 0,75 eV à 1,3 eV, plus préférablement de 0,95 eV à 1,2 eV.

**7.** Dispositif photovoltaïque selon la revendication 1, dans lequel le semi-conducteur nanocristallin comprend un quelconque ou plusieurs nanocristaux comprenant un nanocristal de chalcogénure de plomb, CdSe, CdS, ZnTe, ZnSe, PbS, PbSe, PbTe, HgS, HgSe, HgTe, HgCdTe, CdTe, CZTS, ZnS, CuInS2, CuInGaSe, CuInGaS, Si, InAs, InP, InSb, SnS2, CuS, Ge et Fe2S3.

**8.** Dispositif photovoltaïque selon l'une quelconque revendication précédente, dans lequel la distance moyenne entre les composants luminescents est choisie pour être similaire à la longueur de diffusion des excitons triplets dans le semi-conducteur organique ; où une faible concentration du composant luminescent est nécessaire pour minimiser l'auto-absorption par le composant luminescent.

**9.** Dispositif photovoltaïque selon l'une quelconque revendication précédente, dans lequel la distance moyenne entre les composants luminescents est comprise entre 10 nm et 2000 nm, plus préférablement entre 20 nm et 200 nm.

**10.** Dispositif photovoltaïque selon l'une quelconque revendication précédente, dans lequel la cellule photovoltaïque est pourvue de la première couche photoactive comprenant du silicium.

**11.** Dispositif photovoltaïque selon l'une quelconque des revendications 1 à 10, dans lequel la cellule photovoltaïque est pourvue de la première couche photoactive comprenant du silicium cristallin, silicium amorphe, séléniure de cuivre et d'indium gallium (CIGS), germanium, CdTe, GaAs, l'InGaAs, l'InGaP, l'InP, boîte quantique, oxyde métallique, polymère organique ou semi-conducteurs à petites molécules ou pérovskite comme les semi-conducteurs à perovksite aux halogénures organométalliques et plus particulièrement le chlorure d'iodure de plomb au méthylammonium (CH3NH3Pbl2Cl).

**12.** Matériau composite comprenant un matériau semi-conducteur organique hôte capable de génération multiple d'excitons dispersé avec un matériau luminescent ; dans lequel la bande interdite du matériau luminescent correspond à l'énergie des excitons triplets formés en résultat de la génération multiple d'excitons de sorte que les excitons triplés soient en résonance avec la bande interdite du matériau luminescent et les triplets puissent être transférés dans le matériau luminescent sans rayonnement via un transfert d'énergie selon Dexter ; le matériau luminescent pouvant émettre de la lumière; **caractérisé en ce que** le matériau luminescent comprend un semi-conducteur nanocristal inorganique passivé avec des ligands qui solubilisent le semi-conducteur nanocristal dans des solvants compatibles avec le semi-conducteur organique.

**13.** Système multiplicateur de photons comprenant un film et contenant le matériau composite de la revendication 12, pourvu en outre d'au moins un élément de direction de lumière pour diriger préférentiellement la lumière émise par le matériau luminescent vers une ou une sélection de surfaces ou de bords.

**14.** Dispositif photovoltaïque selon les revendications 1 à 11 ; dans lequel le dispositif de récupération de lumière comprend une couche photoactive semi-conductrice organique capable de génération multiple d'excitons avec des nanocristaux luminescents dispersés à l'intérieur de celle-ci ; dans lequel la bande interdite des nanocristaux est choisie de telle sorte que les excitons triplets, formés en résultat de la génération multiple d'excitons dans le semi-conducteur organique, puissent être transférés dans les nanocristaux, où la dernière étape de transfert d'énergie dans les nanocristaux est engendrée par un transfert d'énergie selon Dexter non-rayonnant.

**15.** Dispositif photovoltaïque selon les revendications 1 à 11, dans lequel le semi-conducteur nanocristallin comprend un quelconque ou plusieurs nanocristaux comprenant de la pérovskite d'halogénure organométallique ou de la pérovskite d'halogénure de plomb et de césium.

FIG. 1

FIG. 2

FIG. 3

FIG. 4

FIG. 5

FIG. 6

FIG. 7

FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20100193011 A, MAPEL

- WO 2014052530 A

### Non-patent literature cited in the description

- **EHRLER, BRUNO et al.** Singlet Exciton Fission-Sensitized Infrared Quantum Dot Solar Cells. *Nano Lett.,* 2012, vol. 12, 1053-1057
- **SCHOLES, G.D et al.** Long range resonance energy transfer in molecular systems. *Annual review of physical chemistry,* 2003, vol. 54, 57-87

- **DEXTER, D. L.** A Theory of Sensitized Luminescence in Solids. *The Journal of Chemical Physics,* 1953